Europäisches Patentamt

European Patent Office

Office européen des brevets

(19)

(11) **EP 0 904 569 B1**

(12) **EUROPÄISCHE PATENTSCHRIFT**

(45) Veröffentlichungstag und Bekanntmachung des Hinweises auf die Patenterteilung:
**04.10.2000 Patentblatt 2000/40**

(51) Int Cl.$^7$: **G03F 7/24**

(21) Anmeldenummer: **97927155.8**

(22) Anmeldetag: **07.06.1997**

(86) Internationale Anmeldenummer:
**PCT/EP97/02975**

(87) Internationale Veröffentlichungsnummer:
**WO 97/48022 (18.12.1997 Gazette 1997/54)**

(54) **VERFAHREN ZUR HERSTELLUNG VON EINE RÄUMLICH GEMUSTERTE OBERFLÄCHE AUFWEISENDEN DRUCK- ODER PRÄGEZYLINDERN**

METHOD OF PRODUCING PRINTING OR EMBOSSING CYLINDERS HAVING A PATTERNED SURFACE

PROCEDE DE PRODUCTION DE CYLINDRES D'IMPRESSION OU DE GAUFRAGE PRESENTANT UNE SURFACE A MOTIF EN RELIEF

(84) Benannte Vertragsstaaten:
**AT CH DE FR GB IT LI NL SE**

(30) Priorität: **12.06.1996 DE 19623352**

(43) Veröffentlichungstag der Anmeldung:
**31.03.1999 Patentblatt 1999/13**

(73) Patentinhaber: **LEONHARD KURZ GMBH & CO.**
**90763 Fürth (DE)**

(72) Erfinder:
• **STORK, Wilhelm**
**D-76131 Karlsruhe (DE)**

• **WILD, Heinrich**
**D-91074 Herzogenaurach (DE)**

(74) Vertreter:
**LOUIS, PÖHLAU, LOHRENTZ & SEGETH**
**Postfach 3055**
**90014 Nürnberg (DE)**

(56) Entgegenhaltungen:
**EP-A- 0 692 741        DE-A- 4 313 111**
**US-A- 3 694 080        US-A- 5 291 317**

**Beschreibung**

Die Erfindung betrifft ein Verfahren zur Herstellung von eine räumlich gemusterte Oberfläche aufweisenden Druck- oder Prägezylindern mittels eines lithographischen Verfahrens, bei dem eine die Oberfläche des Zylinders bildende, strahlungsempfindliche Schicht punktweise fortschreitend mittels eines auf die Schicht abgebildeten oder projizierten Belichtungsstrahles entsprechend dem gewünschten Muster bestrahlt, bereichsweise entfernt bzw. abgetragen und dadurch die Oberfläche des Zylinders gemustert wird.

Es ist bekannt, die Oberfläche von Druckzylindern mittels der sogenannten Laserlithographie zu mustern. Dabei wird ein mit Photolack beschichteter metallischer Zylinder mit Hilfe eines Lasers punktweise entsprechend dem gewünschten Muster belichtet. Nach der Belichtung wird der Photolack an den belichteten Stellen in einem chemischen Entwicklerbad ausgewaschen. An den ausgewaschenen Stellen liegt dann das die Oberfläche des Druckzylinders bildende Metall blank. Dieses wird dann geeigneten Chemikalien, insbesondere Säuren, ausgesetzt, um ein entsprechendes Muster, beispielsweise ein Druckbild, in die Oberfläche des Zylinders zu ätzen. Bei dem bekannten Verfahren werden Punktgrössen von etwa 5 bis 50 μm verwendet. Bei diesen Punktgrössen dauert die Belichtung der gesamten Oberfläche einer Walze von ca. 1 m Länge und 1 m Umfang ca. 1 bis 2 Stunden. Geht man von einer üblicherweise verwendeten Rasterpunktgrösse von 15 μm aus, so berechnet sich hieraus eine Belichtungsfrequenz von 500 kHz bis 1 MHz, die beispielsweise mittels akustooptischer Modulatoren, die als optische Schalter in den Strahlengang des Belichtungsstrahles eingeschaltet sind, erzeugt werden kann. Verwendet man bei diesem Verfahren einen UV-Laser mit einer Wellenlänge von ca. 350 nm, so wird eine Laserleistung im Fokus von ca. 1 W benötigt, wobei während der Belichtung der Druckzylinder mit bis zu 1.600 U/min rotieren kann.

Das bekannte Verfahren ist ohne weiteres für die Strukturierung der Oberfläche von Druckzylindern verwendbar, wo Strukturen einer Grössenordnung von 5 bis 50 um absolut ausreichen, um eine entsprechende Bildqualität zu erzielen. Für bestimmte Anwendungsgebiete, beispielsweise zur Erzeugung von beugungs- oder interferenzoptisch wirksamen Oberflächenstrukturen, wie sie z.B. für Dekorations- oder Sicherheitszwecke eingesetzt werden, werden jedoch wesentlich feinere Strukturen benötigt. Beispielsweise werden bei Reliefstrukturen für Sicherheitselemente, die abhängig von der Veränderung des Beleuchtungs- und/oder Betrachtungswinkels ihr Erscheinungsbild ändern, z.B. die Farbe wechseln, Gitterstrukturen eingesetzt, bei denen die Gitterkonstante deutlich kleiner als 1 um ist. Um derart feine Strukturen zu erzeugen, müsste man bei dem bekannten Verfahren mit Punktgrössen von weniger als 0,5 μm arbeiten. Um mit solch geringen Punktgrössen arbeiten zu können, wäre es zum einen erforderlich, den Belichtungsstrahl äusserst genau zu positionieren, was bei dem bekannten System nicht möglich und wegen der ggf. erforderlichen äusserst genauen Synchronistation von Belichtungsfrequenz und Umdrehungsfrequenz des Zylinders auf jeden Fall mit sehr hohem apparativen Aufwand verbunden wäre. Ausserdem würden sich die Belichtungszeiten pro Punkt bei gleichbleibender Gesamtbelichtungszeit um den Faktor 100 bis 1.000 verkürzen, was ebenfalls nur mit äusserst aufwendigen Massnahmen verwirklicht werden könnte. Bei üblichen Belichtungszeiten für den Einzelpunkt würde sich demgemäss die Gesamtbelichtungszeit um den Faktor 100 bis 1.000 erhöhen. In beiden Fällen würde das Belichtungsverfahren sehr aufwendig und damit unwirtschaftlich werden.

Es besteht deshalb ein Bedürfnis, ein Verfahren der vorstehend erläuterten Art zur Verfügung zu stellen, das es gestattet, bei gut realisierbaren Belichtungszeiten und hinreichend genauer Positionierung der die gewünschte Oberflächenstruktur erzeugenden Bestrahlungspunkte trotzdem gegenüber den bisher üblichen Strukturen wesentlich feinere Strukturen an der Zylinder-Oberfläche zu erzeugen, insbesondere Strukturen, wie sie für entsprechende Beugungs-, Interferenz oder Reflexionseffekte des Lichtes benötigt werden.

Aus der US 5 291 317 ist bereits bekannt, feine Strukturen, insbesondere holographische Gitterstrukturen, die aus einer Vielzahl von Bildpunkten bestehen, dadurch zu erzeugen, dass bei Bestrahlung eines Substrates bereits die einzelnen Bildpunkte durch Verwendung eines strahlformenden Elementes in sich fein strukturiert werden. Bei diesem Verfahren wird jedoch das Substrat vor jeder Bestrahlung, d.h. zur Erzeugung jedes Bildpunktes, genau justiert und während der Bestrahlung absolut nicht bewegt. Diese Vorgehensweise ist bei der Strukturierung von Druckzylindern nicht möglich, da die jeweils zu beschleunigende Masse zu gross wäre. Hält man jedoch den Zylinder während der Belichtung nicht an, ergeben sich aufgrund der üblichen Oberflächengeschwindigkeiten bei Drehzahlen um 1000 U/min sowie bei einer üblichen Belichtungszeit von ca. 1 μsec Unschärfen des projizierten bzw. abgebildeten Strahls, die unter Umständen grösser sind als die Feinheit der Strukturen, z.B. des Abstandes von die Struktur bildenden Gitterlinien. Das Verfahren gemäss US 5 291 317 erscheint daher für die Erzeugung einer Oberflächenmusterung aus einzelnen, fein strukturierten Bildpunkten auf einem rotierenden Zylinder nicht anwendbar.

Der Erfindung liegt die Aufgabe zugrunde, einen Weg aufzuzeigen, der es gestattet, die Oberfläche eines sich ständig bewegenden Zylinders mit einer Vielzahl von sehr fein in sich strukturierten Bildpunkten zu mustern, wobei mit normalen, bisher üblichen Belichtungszeiten und infolgedessen mit Strahlungsquellen normal grosser Leistung gearbeitet werden kann.

Zur Lösung dieser Aufgabe wird erfindungsgemäss vorgeschlagen, das gattungsgemässe Verfahren derart weiterzubilden, dass einerseits zwar entsprechend US 5 291 317 die Bestrahlungspunkte mittels Strahlen erzeugt werden, die vor dem Auftreffen auf die Oberfläche des Zylinders zur Ausbildung feiner Strukturen innerhalb des jeweiligen Bestrahlungspunktes mittels eines strahlformenden Elementes entsprechend dem gewünschten Muster verändert und anschliessend auf die Zylinder-Oberfläche abgebildet oder projiziert werden, andererseits aber zusätzlich das auf die Zylinder-Oberfläche abgebildete oder projizierte Muster des jeweiligen Bestrahlungspunktes synchron zu der Bewegung der Zylinder-Oberfläche entsprechend deren Drehung mitbewegt wird.

Entgegen der Forderung gemäss US 5 291 317, wonach das Substrat vor jeder Belichtung genau eingestellt werden und während der Belichtung stillstehen muss, ermöglicht es das erfindungsgemässe Verfahren, dass sich der Druckzylinder kontinuierlich dreht. Trotzdem wird durch die zur Bewegung der Zylinder-Oberfläche synchrone, d.h. in gleicher Richtung und mit gleicher Geschwindigkeit erfolgende Bewegung des die Struktur auf der Zylinder-Oberfläche bildenden Musters des jeweiligen Bildpunktes erreicht, dass das Muster während der Belichtung gegenüber der Zylinder-Oberfläche stationär erscheint. Dies ermöglicht ein Arbeiten mit Bildpunkten des üblichen Durchmessers von ca. 10 bis 20 µm, ohne dass es zu störenden Unschärfen kommt. Würde man dagegen auf eine "Nachführung" verzichten, erhielte man Unschärfen der Abbildung, die auf jeden Fall deutlich über 1 µm lägen, d.h. grösser wären als der Abstand der Gitterlinien eines für sichtbares Licht konzipierten Gitters. Bei einem Bildpunktdurchmesser vom 10 bis 20 µm können aber auch die üblichen Belichtungsfrequenzen, Laserleistungen und Belichtungszeiten verwendet werden, weshalb existierende Systeme nur geringfügig geändert werden müssen.

Bezüglich des strahlformenden Elementes besteht eine Vielzahl von Möglichkeiten. Bei einer Vielzahl von Oberfächen-Strukturen ist es jedoch günstig, wenn als strahlformendes Element ein strahlbeugendes Element verwendet wird, wobei das strahlbeugende Element zweckmässig ein Beugungsgitter oder ein entsprechend einem Beugungsgitter wirkendes Element ist.

Wird, wie nach der Erfindung vorgesehen, ein strahlformendes Element verwendet, dessen Struktur eine Phasenverschiebung innerhalb des zu formenden Strahls bewirkt und dadurch ein Interferenzmuster erzeugt, so erzielt man den wesentlichen Vorteil, dass sich die Schärfentiefe im Vergleich zu einer konventionellen Abbildung erheblich, nämlich um den Faktor 4, erweitern lässt. Dabei wird als strahlformendes Element zweckmässig eine Phasen-Ronchi-Struktur verwendet. Unter einer Phasen-Ronchi-Struktur, beispielsweise einem Phasen-Ronchi-Gitter, versteht man eine Struktur mit einem rechteckförmigen Oberflächenrelief, wobei üblicherweise die Breite des Grabens und des benachbarten Steges (bei Gittern) gleich gross ist. Die Dicke von Phasen-Ronchi-Gittern bzw.-Strukturen wird so gewählt, dass die lokale Phasenverzögerung zwischen Steg und benachbartem Graben gerade 180° entspricht. Dabei kann sowohl mit Transmission als auch mit Reflexion gearbeitet werden. Für die Erzeugung beispielsweise von Liniengittern werden linienförmige Phasen-Ronchi-Strukturen benötigt. Für Kreuz- bzw. Vierfach-Strahlteiler wird ein entsprechendes Schachbrett-Relief benötigt. Mit derartigen Strahlformungselementen lassen sich Interferenzmuster im Fokus einer Belichtungseinrichtung erzeugen, für die - im Vergleich zu einer konventionellen Abbildung - nur die halbe numerische Apertur benötigt wird, was bedeutet, dass sich bei Verwendung derartiger Elemente als strahlformende Elemente die Schärfentiefe, die ja mit dem Quadrat der Apertur geht, um den Faktor 4 erweitern lässt. Beispielsweise lässt sich bei einem Gitter mit einer Gitterkonstanten von 0,7 µm und bei Verwendung von Licht einer Wellenlänge von 350 nm eine Schärfentiefe von wenigstens 6 µm erreichen, wobei allerdings Simulationsrechnungen gezeigt haben, dass in diesem Fall sogar eine Schärfentiefe von wenigstens ± 5 µm erreichbar ist. Diese Schärfentiefe von etwa 10 µm stellt einen erheblichen Vorteil dar, weil hierdurch die Scharfstellung auf die Oberfläche des zu bearbeitenden Zylinders erheblich vereinfacht wird.

Werden akustooptische Wandler als strahlformende Elemente verwendet, lässt sich in gleicher Weise eine Verbesserung im Sinne einer erweiterten Schärfentiefe wie bei Verwendung von Phasen-Ronchi-Strukturen erreichen, da sich mit akustooptischen Wandlern im Bragg-Regime eine Strahlformung wie bei Phasen-Ronchi-Strukturen erzeugen lässt.

Die synchrone Bewegung des Musters der Bildpunkte kann in unterschiedlicher Weise bewirkt werden. Beispielsweise ist vorgesehen, dass das strahlformende Element zur Erzeugung einer Bewegung des jeweils den Bestrahlungspunkt bildenden, abgebildeten oder projizierten Strahles synchron zu der Bewegung der Zylinder-Oberfläche bewegt wird. Insbesondere kann sich das strahlformende Element synchron mit der Drehbewegung des Zylinders mitdrehen. Die Bewegung des abgebildeten oder projizierten Strahles insgesamt kann beispielsweise mittels Galvanometerspiegeln, rotierenden Polygonspiegeln oder aber auch mit akustooptischen Deflektoren durchgeführt werden. In diesem Zusammenhang müsste der Strahl im allgemeinen eine sägezahnartige Bewegung durchführen, und zwar eine vergleichsweise langsame Bewegung in Bewegungsrichtung der Zylinder-Oberfläche und eine sehr schnelle, in die Gegenrichtung führende Rückstell-Bewegung. Entsprechend der Frequez der Zick-zack-Bewegung lässt sich der von dem Strahl zu überstreichende Winkelbereich klein halten. Dies ist auch deswegen erforderlich, um den jeweils vorhandenen Schärfentiefenbereich einzuhalten.

Es kann weiter zweckmässig sein, wenn ein strahlformendes Element verwendet wird, dessen strahlformende Eigenschaften veränderlich sind, wobei als derartiges strahlformendes Element zweckmässig ein akustooptischer Wandler verwendet wird. Die Verwendung eines strahlformenden Elementes mit veränderlichen Eigenschaften bietet dabei mehrere Vorteile. Zum einen ist bei Einsatz eines strahlformenden Elementes dieser Art die Möglichkeit gegeben, die Struktur der einzelnen Bestrahlungspunkte von Punkt zu Punkt oder von Punktgruppe zu Punktgruppe zu variieren und auf diese Weise mit vergleichsweise geringem Aufwand die Oberflächenstruktur des Druckzylinders zu variieren.

Insbesondere jedoch nicht nur bei Verwendung eines akustooptischen Wandlers als strahlformendes Element besteht erfindungsgemäss die Möglichkeit, dass das strahlformende Element derart angesteuert wird, dass es eine synchron zur Drehung der Zylinder-Oberfläche erfolgende Bewegung des Musters erzeugt, wodurch sich in sehr einfacher Weise die angestrebte quasi stationäre Anordnung der Bestrahlungspunkte auf der Druckzylinder-Oberfläche erreichen lässt.

Wenn die Oberfläche des Zylinders zur Erzeugung des gewünschten Musters mittels der Bestrahlungspunkte zeilenweise bestrahlt wird, lässt sich im allgemeinen eine recht saubere, regelmässige Strukturierung erreichen. Für die Mehrzahl der Anwendungsfälle ist es jedoch zweckmässiger, wenn, wie nach der Erfindung weiter vorgesehen, die Oberfläche des Zylinders schraubenlinienförmig in den Bestrahlungspunkten zur Erzeugung des gewünschten Musters bestrahlt wird, wobei sich dann quasi eine absolut nahtlose Strukturierung der Zylinder-Oberfläche erzielen lässt. Selbstverständlich ist es auch möglich, die zeilenweise und schraubenlinenförmige Anordnung in geeigneter Kombination vorzusehen.

Vor allem bei schraubenlinienförmiger Bestrahlung wird vorteilhafterweise derart vorgegangen, dass die Bestrahlungspunkte in benachbarten Zeilen oder Schraubenlinien gegeneinander leicht versetzt angeordnet werden. Dies hat den Vorteil, dass gewisse Unregelmässigkeiten in der Positionierung der Bestrahlungspunkte nicht störend in Erscheinung treten, weil quasi von Haus aus benachbarte Bestrahlungspunkte nicht genau zueinander ausgerichtet sind. Da die Bestrahlungspunkte ja nur sehr klein sind und damit deutlich unter dem Auflösungsvermögen des menschlichen Auges liegen, werden diese Unregelmässigkeiten vom Betrachter nicht registriert, was dann aber dazu führt, dass weitere Unregelmässigkeiten in der Positionierung ebenfalls nicht störend auffallen.

Generell sollte bei dem Verfahren gemäss der Erfindung so vorgegangen werden, dass einander benachbarte Bestrahlungspunkte gegeneinander um ein unter dem Auflösungsvermögen des unbewaffneten Auges liegendes Mass gegenüber einer der regelmässigen Anordnung der Bestrahlungspunkte entsprechenden Soll-Lage versetzt angeordnet werden, wobei die Versetzung der Bestrahlungspunkte über eine grössere, eine Vielzahl von Bestrahlungspunkten aufweisende Zylinder-Teilfläche statistisch ungleichförmig vorgesehen ist. Zweckmässig sind in diesem Fall sämtliche Bestrahlungspunkte derart angeordnet, dass das ihnen jeweils entsprechende Muster gegenüber der Soll-Lage (zentrischen Anordnung des Musters der einzelnen Bestrahlungspunkte) versetzt ist. Wenn derart vorgegangen wird, ist ein Betrachter absolut nicht mehr in der Lage, geringfügige Ungenauigkeiten bei der Musterung festzustellen. Es ergibt sich vielmehr für das gesamte Bild eine - sehr geringe - Unschärfe, die etwaige Unregelmässigkeiten bei der Positionierung der einzelnen Bestrahlungspunkte zuverlässig überdeckt.

Eine sehr vielseitige Musterung des Druckzylinders lässt sich dann erzielen, wenn gemäss einem weiteren Vorschlag der Erfindung unterschiedlichen Bestrahlungspunkten unterschiedliche Muster zugeordnet werden, was sich vor allem dann leicht realisieren lässt, wenn ein strahlformendes Element verwendet wird, dessen strahlformende Eigenschaften sich verändern lassen.

Als strahlenformendes Element können die unterschiedlichsten Arten verwrendet werden. Soll beispielsweise die Zylinder-Oberfläche eine Gitterstruktur aufweisen, wird man als strahlformendes Element ein Element einsetzen, welches bereits eine entsprechende, zur Erzeugung eines Gitters auf der Oberfläche des Zylinders führende Aufspaltung des Lichtes im Belichtungsstrahl bewirkt. Beispielsweise kann ein Gitter auf der Oberfläche des Zylinders dadurch erzeugt werden, dass das strahlformende Elemente durch Beugung Lichtstrahlen unterschiedlicher Beugungsordnung erzeugt, von denen dann zwei im Fokus, d.h. auf der Zylinder-Oberfläche, vereinigt werden und durch Interferenz eine entsprechende Streifenstruktur an der Zylinder-Oberfläche ergeben. Ein geeignetes Gitter könnte z.B. das weiter oben bereits erwähnte Phasen-Ronchi-Gitter sein.

Strahlformende Elemente, deren strahlformende Eigenschaften veränderlich sind, lassen sich auf verschiedene Weise verwirklichen. Beispielsweise können Strukturen verwendet werden, die mechanisch bewegt werden. Geht es z.B. darum, eine Bewegung des durch Interferenz erzeugten Musters im Fokus zu erreichen, kann ein entsprechend bewegtes Strahlteilergitter eingesetzt werden. Es wäre z.B. denkbar, ein als Phasen-Ronchi-Gitter ausgebildetes Sterngitter mit radialen Strahlen zu verwenden, bei dem im Aussenbereich die Gitterlinien bei kleinem Lichtstrahl-Durchmesser nahezu parallel verlaufen und das entsprechend um eine zentrische Achse rotiert. Wenn man den Strahl ausserhalb des Zentrums durch das Sterngitter treten lässt, erfolgt eine Aufspaltung, wobei eine Frequenzverschiebung proportional zur Rotationsgeschwindigkeit auftritt. Bei Beugung an dem rotierenden Phasengitter wird die Lichtfrequenz der Beugungsordnungen, die in Bewegungsrichtung gebeugt werden, um die Dopplerfrequenz erhöht, während die Lichtfrequenzen der gegen die Bewegungsrichtung gebeugten Ordnungen um die Dopplerfrequenz erniedrigt werden. Bei Vereinigung dieser Strahlen im Fokus eilt dann die Phase des positiv verschobenen Teil-Strahls der Phase des negativ verschobenen voraus, wodurch man ein Wandern des Interferenzmusters im Fokus erzielt. Da sich infolge der Interferenz von Doppler-verschobenen Strahlen, die jeweils um den gleichen Betrag, aber in verschiedener Richtung verschoben wurden, eine Differenzfrequenz in Höhe der zweifachen Dopplerfrequenz ergibt, muss die Bewegungsgeschwindigkeit des rotierenden Gitters nur der Hälfte der Bewegungsgeschwindigkeit des Zylinders entsprechen, um eine exakte Nachführung zu erzielen.

Sowohl die Veränderung der Struktur des Musters als auch insbesondere dessen Bewegung kann durch unterschiedlichste Arten akustooptischer Wandler bzw. Modulatoren bewirkt werden.

Üblicherweise wird bei einem akustooptischen Wandler der akustooptische Effekt durch Einkopplung von Schallwellen in einen Kristall (TeO$_2$ oder anderes Material) bewirkt. Die sich ausbreitende Schallwelle erzeugt eine periodische Dichteschwankung im Kristall, die eine periodische Brechungsindex-Veränderung zur Folge hat. Durchleuchtet man einen akustisch angeregten Kristall, so wird das Licht entsprechend den periodischen Dichteschwankungen gebeugt, was dazu führt, dass das durch Interferenz und entsprechende Abbildung erzeugte Bild sich entsprechend der Veränderung in dessen Brechungsindex in den verschiedenen Regionen des akustooptischen Wandlers verändert (bezüglich der Ausführung akustooptischer Wandler wird beispielsweise hingewiesen auf das Buch "Optical Waves in Crystals" von Yariv und Yeh, Kapitel 9 und 10 (Seite 318 ff.), J. Wiley & Sons-Verlag, 1984).

Zweckmässig verwendet man als akustooptische Wandler solche, die ausreichend dick sind, um im Bragg-Regime betrieben werden zu können. Bestrahlt man eine derartige Zelle unter dem Bragg-Winkel, erzielt man durch die Volumenbeugung eine hohe Beugungseffizienz und es entstehen im allgemeinen nur zwei Ausgangsstrahlen, nämlich der durchgehende Strahl der 0.ten Beugungsordnung sowie der gebeugte Strahl der 1.ten Beugungsordnung, die dann als Strahlen im Fokus zur Vereinigung kommen wenn die Frequenz der beiden Strahlen gegeneinander dort interferieren und ein feines Interferenzmuster bilden. Arbeitet man mit Phasen-Ronchi-Strukturen als strahlformendes Element (wobei dann nur eine mechanische Bewegung möglich wäre), wird man vorteilhafterweise die Strahlführung so vornehmen, dass jeweils die - 1.te und die + 1.te Beugungsordnung ausgenutzt werden. Benutzt man ein Phasen-Ronchi-Gitter richtiger Tiefe, erhält man keine 0.te Beugungsordnung. Die beiden 1.ten Ordnungen erhalten dann ca. 80 % der eingestrahlten Energie. Die höheren Ordnungen haben zusammen nur 20 %, die meist einen so hohen Ablenkwinkel aufweisen, dass sie nicht mehr durch die Beleuchtungsoptik treten, so dass meist keine extra Blende zum Ausblenden der höheren Beugungsordnungen verwendet werden muss.

Anstelle einer Bragg-Zelle könnte man auch sogenannte SAW-Zellen (Surface Acoustic Waves) verwenden, die dünner sind und sinusoidale Oberflächenverwerfungen und damit eine wandernde Oberflächenstruktur erzeugen, was im allgemeinen zu vielen Beugungsordnungen führt (ähnlich einer dünnen Bragg-Zelle, die im Raman-Nath-Gebiet arbeitet). In diesem Falle müssen höhere Beugungsordnungen je nach dem gewünschten Muster ausgeblendet werden.

Eine kompliziertere Bewegung des Musters liesse sich unter Umständen auch erreichen, wenn man akustooptische Wandler einsetzt, die in der Lage sind, eine Veränderung der optischen Eigenschaften der Zelle nicht nur in einer Richtung (X-Richtung) sondern auch in der hierzu senkrechten Richtung (Y-Richtung) zu bewirken. Bei Verwendung derartiger akustooptischer Wandler wäre es auch denkbar, nicht das Muster an sich sondern den gesamten, auf die Zylinder-Oberfläche abgebildeten bzw. projizierten Spot zu bewegen.

Abhängig von dem Material, aus dem die strahlungsempfindliche Schicht auf der Oberfläche des Zylinders besteht, kann mit den unterschiedlichsten Belichtungssystemen gearbeitet werden. Beispielsweise wäre es denkbar, als Belichtungsstrahlen Röntgen- oder Elektronenstrahlen zu verwenden, die vergleichsweise engergiereich sind. Vorzugsweise wird man jedoch erfindungsgemäss derart vorgehen, dass die strahlungsempfindliche Schicht auf dem Zylinder eine photoempfindliche Schicht ist, die mittels Lichtstrahlug belichtet wird, wobei zweckmässigerweise zur Bestrahlung der Zylinder-Oberfläche Laserstrahlung verwendet wird, da sich diese sehr sauber fokussieren lässt und einen entsprechend hohen Energiegehalt besitzt, um eine saubere, entsprechend fein strukturierte Belichtung der photoempfindlichen Schicht auf der Oberfläche des Zylinders zu gewährleisten.

Weitere Merkmale, Einzelheiten und Vorteile der Erfindung ergeben sich aus der folgenden beispielsweisen Beschreibung des Verfahrens anhand der Zeichnung.

Es zeigen, jeweils schematisch -:

Figur 1    eine Anordnung zur Durchführung des Verfahrens gemäss der Erfindung;

Figur 2    den Strahlengang im Bereich des Fokus bei Erzeugung einer Gitterstruktur durch Interferenz zweier Strahlen;

Figur 3    zwei Möglichkeiten der punktweisen Belichtung der Druckzylinder-Oberfläche;

Figur 4    einen Ausschnitt aus einer Druckzylinder-Oberfläche und

Figur 5      eine Darstellung zur Erläuterung der gegenseitigen Versetzung der Bestrahlungspunkte.

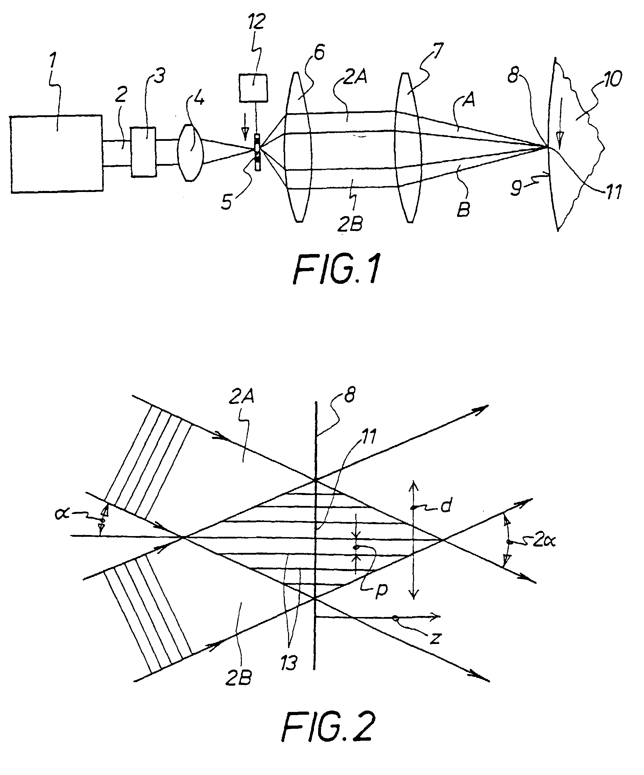

In Figur 1 ist eine Anordnung dargestellt, wie sie bei Durchführung des Verfahrens gemäss der Erfindung eingesetzt werden kann. Bei dem gezeigten Ausführuntsbeispiel sei angenommen, dass mit Laserstrahlung gearbeitet und eine Photolackschicht auf der Zylinder-Oberfläche bestrahlt werden soll.

Zu diesem Zweck umfasst die in Figur 1 gezeigte Anordnung einen Laser 1, beispielsweise einen UV-Laser, der mit einer Wellenlänge von ca. 350 nm arbeitet und eine Leistung von etwa 1 W aufweist. Der aus dem Laser 1 austretende Laserstrahl 2 durchsetzt einen akustooptischen Modulator 3, der im wesentlichen nur die Funktion eines optischen Schalters, d.h. die Aufgabe, den Laserstrahl 2 entsprechend der gewünschten Taktfrequenz der Belichtung ein- und auszuschalten, hat. Eine Linse 4 erzeugt auf einem strahlformenden Element 5, z.B. einem Strahlteilergitter, einen Beleuchtungspunkt einer vorgegebenen, gewünschten Grösse.

Das strahlformende Element 5 führt durch Beugung eine Strahlaufspaltung in mehrere Strahlen durch, wobei gemäss dem Ausführungsbeispiel angenommen werden soll, dass das strahlformende Element 5 aus dem Strahl 2 zwei Teilstrahlen 2A und 2B, z.B. die Beugungsstrahlen der + 1.ten und - 1.ten Ordnung, erzeugt. Diese Strahlen 2A und 2B werden durch die aus den Linsen 6 und 7 bestehende Optik entsprechend der Darstellung der Figur 2 wieder vereinigt, wobei sich im Fokus 8 auf der Oberfläche 9 des Druckzylinders 10 Bestrahlungspunkte 11 mit einem entsprechenden Interferenzmuster, z.B. einer Gitterstruktur, ausbilden. Die Form des Interferenzmusters hängt dabei von Art und Ausbildung des strahlformenden Elementes 5, z.B. des Strahlteilergitters, ab.

In Figur 1 ist schliesslich noch ersichtlich, dass das strahlformende Element 5 mit einer Steuereinrichtung 12 verbunden ist, wodurch angedeutet werden soll, dass es sich bei dem strahlformenden Element 5 um ein Element handelt, das, beispielsweise abhängig von entsprechenden Synchronisationssignalen an der Steuereinrichtung 12, beweglich oder bezüglich seiner optischen Eigenschaften veränderlich ist, um so das Muster bzw. die Lage der Strukturen in den Bestrahlungspunkten 11 verändern oder die Bestrahlungspunkte 11 über die Zylinder-Oberfläche synchron zu deren Bewegung bewegen zu können.

Das strahlformende Element 5 kann zweckmässig von einem akustooptischen Wandler entsprechenden Aufbaus gebildet sein, was beispielsweise die Möglichkeit gibt, eine gewisse Gitterstruktur bei entsprechender Ansteuerung des strahlformenden Elementes 5 synchron zur Drehbewegung des Druckzylinders 10 entlang der Ebene des strahlformenden Elementes 5, beispielsweise in Richtung der Pfeile in Figur 1, laufen zu lassen.

In Figur 2 ist schematisch angedeutet, wie im Fokus 8 auf der Oberfläche 9 des Druckzylinders 10 ein Bestrahlungspunkt 11 mit einer durch die Gitterlinien 13 angedeuteten Struktur erzeugt werden kann.

Zu diesem Zwecke werden die beiden Teil-Lichtstrahlen 2A und 2B, die vom strahlformenden Element 5, z.B. einem Strahlteilergitter, durch Beugung erzeugt sind und eine entsprechende Phasenverschiebung aufweisen, im Fokus 8 überlagert, wodurch eine Interferenzstruktur in der Form der Gitterstreifen 13 entsteht.

Die Periode p der Gitterstreifen im Fokus 8 lässt sich dabei nach folgender Formel bestimmen -:

$$p = \lambda : [2 \cdot \sin \alpha ].$$

Geht man z.B. bei einer Wellenlänge von 350 nm des verwendeten Lasers davon aus, dass die Periode p der Gitterstruktur im Bestrahlungspunkt 11 0,7 $\mu$m betragen soll, so ergibt sich aufgrund vorstehender Formel für $\alpha$ ein Winkel von ca. 15° bzw. eine numerische Apertur sina von 0,25.

Es ist weiterhin wesentlich, dass mit hinreichender Schärfentiefe gearbeitet wird, um gewisse Unregelmässigkeiten im Durchmesser bzw. Rundlauf des zu musternden Zylinders auszugleichen.

Wenn für diesen Fall angenommen wird, dass der Durchmesser d des bzw. der Bestrahlungspunkte 15 $\mu$m beträgt, berechnet sich unter Berücksichtung der Apertur von 0,25 näherungsweise eine Schärfentiefe z von wenigstens $\pm$ 5 $\mu$m, was üblicherweise ausreicht, um vorhandene Toleranzen zu überbrücken.

Die Oberfläche 9 des Zylinders 10 wird nun punktweise fortschreitend belichtet, d.h. es wird ein Bestrahlungspunkt 11 nach dem anderen auf der Oberfläche 9 des Zylinders 10 abgebildet bzw. auf diese Oberfläche 9 projiziert, wobei die einzelnen Bestrahlungspunkte 11 bereits entsprechend strukturiert sind.

Nach der Belichtung wird die entsprechend photoempfindliche Schicht auf der Oberfläche 9 des Zylinders 10 ggf. behandelt, um die Oberflächenschicht anschliessend in den nichtbelichteten Bereichen vollständig und in den belichteten Bereichen entsprechend der gewünschten Struktur beispielweise durch Ablösen entfernen zu können. Hieran anschliessend erfolgt dann die Ätzung der Oberfläche 9 des Zylinders 10 in üblicher Weise, um die eigentliche Zylinder-Oberfläche zu strukturieren.

Selbstverständlich kann nicht nur entsprechend dem in Verbindung mit Figur 1 erläuterten Ausführungsbeispiel mit Laserlicht gearbeitet werden. Bei Verwendung geeigneter Beschichtungen an der Oberfläche 9 des Zylinders 10 können auch andere Arten von Belichtungsstrahlen, insbesondere Röntgen- oder Elektronenstrahlen eingesetzt werden, wodurch ggf. eine weitere Verfeinerung der Struktur erzielbar ist. Es ist ausserdem so, dass das Verfahren gemäss der Erfindung grundsätzlich nicht nur verwendet werden kann, wenn es darum geht, Oberflächenbereiche des Zylinders abzutragen. Es wären durchaus auch Arten der Verfahrensführung denkbar, bei denen abhängig von der entsprechenden Bestrahlung auf die Oberfläche 9 des Zylinders Material aufgebracht wird, beispielsweise durch Übertragung von einer an der Oberfläche 9 des Zylinders 10 anliegenden Schicht.

Die fortschreitende Musterung der Oberfläche 9 des Zylinders 10 mit Bestrahlungspunkten 11 kann in unterschiedlicher Weise erfolgen.

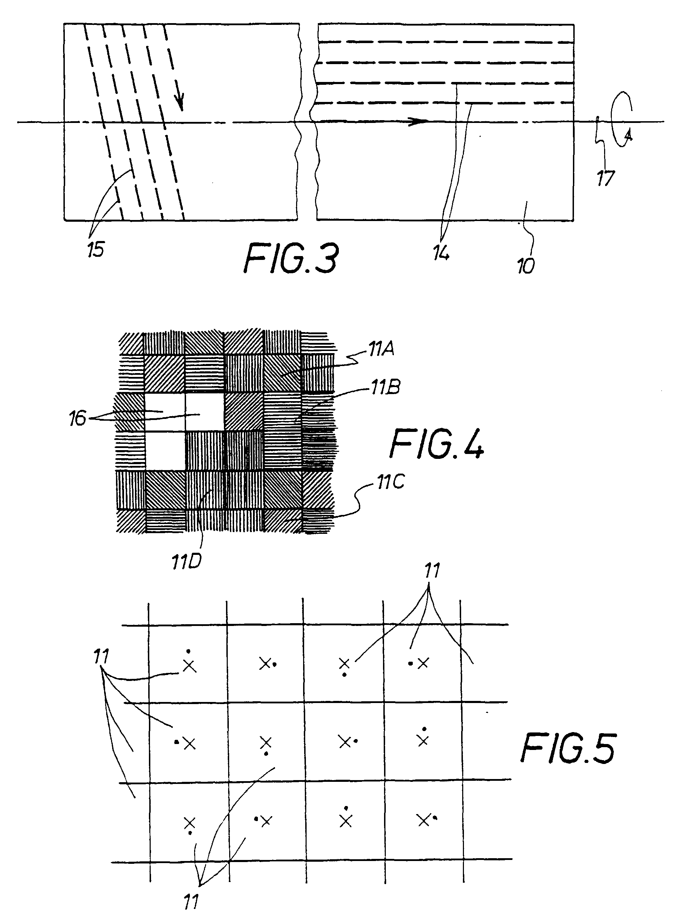

Beispielsweise ist es möglich, entsprechend der schematischen Darstellung in Figur 3, rechts die Bestrahlungspunkte zeilenweise entlang der strichlierten Linien 14 vorzusehen, wobei eine Zeile 14 nach der anderen "geschrieben" wird.

Vor allem unter Berücksichtigung der möglicherweise entstehenden Ungenauigkeiten und zur Verkürzung der Bearbeitungszeit wird es jedoch zweckmässig sein, den Druckzylinder 10 in der in Figur 3 links skizzierten Weise zu mustern, d.h. die Bestrahlungspunkte 11 entlang Schraubenlinien 15 anzuordnen, wobei in dem gezeigten Ausführungsbeispiel davon ausgegangen wird, dass die Schraubenlinien 15 zusätzlich noch ineinander verschachtelt sind.

Grundsätzlich ist es möglich, bei der Strukturierung der Oberflächen 9 von Zylindern 10 gemäss der Erfindung so vorzugehen, dass sämtliche Bestrahlungspunkte 11 die gleiche Struktur aufweisen und nur zwischen Bereichen mit Bestrahlungspunkten 11 und Bereichen 16, in denen keine Bestrahlung stattfand, wo also die Oberfläche 9 des Zylinders 10 unverändert bleibt, zu unterscheiden.

In Figur 4 ist jedoch angedeutet, dass die Strukturierung der Oberfläche 9 des Zylinders 10 noch vielseitiger ausgebildet werden kann, wenn die einzelnen Bestrahlungspunkte 11A, 11B, 11C und 11D jeweils in sich unterschiedliche Struktur aufweisen, wie dies in Figur 4 durch die Art der Schraffur angedeutet ist, wobei jeweils sämtliche unmittelbar benachbarten Bestrahlungspunkte 11 unterschiedlich strukturiert sein können, aber auch die Möglichkeit gegeben ist, grössere Bereiche gleich zu strukturieren, indem Bestrahlungspunkte (z.B. 11B, 11D in Figur 4) gleicher Musterung nebeinander gesetzt werden.

Nachdem es bei der Feinheit des erfindungsgemäss erzeugten Musters nicht möglich ist, von Bestrahlungspunkt zu Bestrahlungspunkt das strahlformende Element 5 auszuwechseln, wird hier vorteilhafterweise derart vorgegangen, dass strahlformende Elemente 5 verwendet werden, deren Struktur bzw. erzeugte Struktur über die Steuereinrichtung 12 veränderlich ist. Hier gibt es entsprechende akustooptische Wandler, die z.B. die Periode des erzeugten Gitters variieren können. Es ist aber auch möglich, bei Verwendung geeigneter Wandler und entsprechender Ansteuerung eine Drehung oder Verzerrung des vom Wandler 5 erzeugten Musters hervorzurufen und auf diese Weise das Muster verschiedener Bestrahlungspunkte 11 zu variieren.

In Figur 5 ist schliesslich angedeutet, dass es sehr zweckmässig sein kann, das Muster benachbarter Bestrahlungspunkte 11 von Bestrahlungspunkt zu Bestrahlungspunkt gegenüber den in Figur 5 durch ein x gekennzeichneten tatsächlichen Zentren der einzelnen Bestrahlungspunkte 11 zu versetzen, wobei der tatsächliche Mittelpunkt des in dem jeweiligen Bestrahlungspunkt 11 vorhandenen Musters in Figur 5 durch einen kleinen Punkt angedeutet ist.

Diese bewusste Versetzung des Musters benachbarter Bestrahlungspunkte 11 gegenüber ihrem Zentrum x führt zu einer gewissen Unschärfe des gesamten, auf der Oberfläche 9 des Zylinders 10 durch die Bestrahlungspunkte 11 erzeugten Bildes, wodurch erreicht wird, dass möglicherweise bei der Herstellung auftretende Ungenauigkeiten für den normalen Betrachter nicht sichtbar sind. Dies ist erforderlich, weil Versuche der Anmelderin gezeigt haben, dass z.B. regelmässige Versetzungen von Gitterstrukturen gegeneinander von einem Betrachter bereits wahrgenommen werden, wenn diese Versetzungen wesentlich geringer sind als ein Mass, das dem normalen Auflösungsvermögen des menschlichen Auges entspricht.

Figur 5 lässt auch erkennen, dass die Versetzung des Musters gegenüber dem Zentrum x eines Bestrahlungspunktes 11 jeweils in sämtlichen einander benachbarten Bestrahlungspunkten unterschiedlich vorgenommen ist, was wichtig ist, um nicht durch mehrfache gleichmässige Versetzung des Musters in benachbarten Bestrahlungspunkten doch einen optisch störenden Effekt hervorzurufen.

Die Versetzung des Musters der Bestrahlungspunkte 11 gegenüber dem jeweiligen Zentrum X lässt sich ebenfalls durch entsprechende Ansteuerung geeigneter Wandler 5 erreichen.

### Patentansprüche

1. Verfahren zur Herstellung von eine räumlich gemusterte Oberfläche (9) aufweisenden Druck- oder Prägezylindern (10) mittels eines lithographischen Verfahrens, bei dem eine die Oberfläche (9) des Zylinders (10) bildende, strahlungsempfindliche Schicht punktweise fortschreitend mittels eines auf die Schicht abgebildeten oder projizierten Belichtungsstrahles (2) entsprechend dem gewünschten Muster bestrahlt, bereichsweise entfernt bzw. abgetragen und dadurch die Oberfläche (9) des Zylinders (10) gemustert wird,
**dadurch gekennzeichnet,**
dass die Bestrahlungspunkte (11) mittels Strahlen (2A, 2B) erzeugt werden, die vor dem Auftreffen auf die Oberfläche (9) des Zylinders (10) zur Ausbildung feiner Strukturen innerhalb des jeweiligen Bestrahlungspunktes (11) mittels eines strahlformenden Elementes (5) entsprechend dem gewünschten Muster verändert und anschliessend auf die Zylinderoberfläche (9) abgebildet oder projiziert werden, und dass das auf die Zylinder-Oberfläche (9) abgebildete oder projizierte Muster des jeweiligen Bestrahlungspunktes (11) synchron zu der Bewegung der Zylinder-Oberfläche (9) entsprechend deren Drehung mitbewegt wird.

2. Verfahren nach Anspruch 1,
**dadurch gekennzeichnet,**
dass als strahlformendes Element (5) ein strahlbeugendes Element, vorzugsweise ein Beugungsgitter oder ein entsprechend einem Beugungsgitter wirkendes Element verwendet wird.

3. Verfahren nach Anspruch 1 oder 2,
**dadurch gekennzeichnet,**
dass ein strahlformendes Element (5) verwendet wird, dessen Struktur eine Phasenverschiebung innerhalb des zu formenden Strahls bewirkt und dadurch ein Interferenz-Muster erzeugt.

4. Verfahren nach Anspruch 3,
**dadurch gekennzeichnet,**
dass als strahlformendes Element (5) eine Phasen-Ronchi-Struktur verwendet wird.

5. Verfahren nach einem der vorhergehenden Ansprüche,
**dadurch gekennzeichnet ,**
dass das strahlformende Element (5) zur Erzeugung einer Bewegung des jeweils den Bestrahlungspunkt (11) bildenden, abgebildeten oder projizierten Strahles (2A, 2B) synchron zu der Bewegung der Zylinder-Oberfläche (9) bewegt wird.

6. Verfahren nach einem der vorhergehenden Ansprüche,
**dadurch gekennzeichnet,**
dass ein strahlformendes Element (5) verwendet wird, dessen strahlformende Eigenschaften veränderlich (12) sind.

7. Verfahren nach Anspruch 6,
**dadurch gekennzeichnet,**
dass als strahlformendes Element (5) ein akustooptischer Wandler verwendet wird.

8. Verfahren nach Anspruch 6 oder 7,
**dadurch gekennzeichnet,**
dass das strahlformende Element (5) derart angesteuert (12) wird, dass es eine synchron zur Drehung der Zylinder-Oberfläche (9) erfolgende Bewegung des Musters erzeugt.

9. Verfahren nach einem der vorhergehenden Ansprüche,
**dadurch gekennzeichnet,**
dass die Oberfläche (9) des Zylinders (10) zur Erzeugung des gewünschten Musters mittels der Bestrahlungspunkte (11) zeilenweise (14) und/oder schraubenlinienförmig (15) bestrahlt wird.

10. Verfahren nach Anspruch 9,
**dadurch gekennzeichnet,**
dass die Bestrahlungspunkte (11) in benachbarten Zeilen (14) oder Schraubenlinien (15) gegeneinander leicht versetzt angeordnet werden (Figur 5).

11. Verfahren nach einem der vorhergehenden Ansprüche,
**dadurch gekennzeichnet,**
dass einander benachbarte Bestrahlungspunkte (11) gegeneinander um ein unter dem Auflösungsvermögen des unbewaffneten Auges liegendes Mass gegenüber einer der regelmässigen Anordnung der Bestrahlungspunkte (11) entsprechenden Soll-Lage (x) versetzt angeordnet werden, wobei die Versetzung der Bestrahlungspunkte (11) über eine grössere, eine Vielzahl von Bestrahlungspunkten (11) aufweisende Zylinder-Teilfläche statistisch ungleichförmig vorgesehen ist (Figur 5).

12. Verfahren nach Anspruch 11,
**dadurch gekennzeichnet**
dass sämtliche Bestrahlungspunkte (11) derart angeordnet sind, dass das ihnen jeweils entsprechende Muster gegenüber der Soll-Lage (x) [zentrischen Anordnung des Musters der einzelnen Bestrahlungspunkte (11)] versetzt ist.

13. Verfahren nach einem der vorhergehenden Ansprüche,
**dadurch gekennzeichnet,**
dass unterschiedlichen Bestrahlungspunkten (11A, 11B, 11C, 11D) unterschiedliche Muster zugeordnet werden (Figur 4).

14. Verfahren nach einem der vorhergehenden Ansprüche,
**dadurch gekennzeichnet,**
dass die strahlungsempfindliche Schicht auf dem Zylinder (10) eine photoempfindliche Schicht ist, die mittels Lichtstrahlung belichtet wird.

15. Verfahren nach einem der vorhergehenden Ansprüche,
**dadurch gekennzeichnet**,
dass zur Bestrahlung der Zylinder-Oberfläche (9) Laserstrahlung (1, 2) verwendet wird.

**Claims**

1. Method of producing printing or embossing cylinders (10) having a three-dimensionally patterned surface (9) by means of a lithographic process, in which a radiation-sensitive layer forming the surface (9) of the cylinder (10) is progressively irradiated point by point in accordance with the desired pattern by means of an illuminating beam (2) projected onto the layer and is removed or eroded in some areas and, as a result, the surface (9) of the cylinder (10) is patterned, characterized in that the irradiation points (11) are produced by means of beams (2A, 2B) which, before they are incident on the surface (9) of the cylinder (10), are changed in accordance with the desired pattern by means of a beam-shaping element (5), in order to form fine structures within the respective irradiation point (11), and are subsequently projected onto the surface (9) of the cylinder, and in that the pattern of the respective irradiation point (11) projected onto the surface (9) of the cylinder is moved simultaneously and synchronously with the movement of the surface (9) of the cylinder, in accordance with the rotation of the latter.

2. Method according to Claim 1, characterized in that the beam-shaping element (5) used is a beam-diffracting element, preferably a diffraction grating or an element acting in a way corresponding to a diffraction grating.

3. Method according to Claim 1 or 2, characterized in that a beam-shaping element (5) is used whose structure effects a phase shift within the beam to be shaped and, as a result, produces an interference pattern.

4. Method according to Claim 3, characterized in that the beam-shaping element (5) used is a Ronchi phase structure.

5. Method according to one of the preceding claims, characterized in that the beam-shaping element (5) is moved synchronously with the movement of the surface (9) of the cylinder in order to produce a movement of the projected beam (2A, 2B) respectively forming the irradiation point (11).

6. Method according to one of the preceding claims, characterized in that a beam-shaping element (5) is used whose beam-shaping properties can be varied (12).

7. Method according to Claim 6, characterized in that the beam-shaping element (5) used is an acousto-optical converter.

8. Method according to Claim 6 or 7, characterized in that the beam-shaping element (5) is activated (12) in such a way that a movement of the pattern is produced which is synchronous with the rotation of the surface (9) of the cylinder.

9. Method according to one of the preceding claims, characterized in that in order to produce the desired pattern, the surface (9) of the cylinder (10) is irradiated line by line (14) and/or helically (15) by means of the irradiation points (11).

10. Method according to Claim 9, characterized in that the irradiation points (11) in adjacent lines (14) or helices (15) are arranged to be slightly offset from one another (Figure 5).

11. Method according to one of the preceding claims, characterized in that adjacent irradiation points (11) are arranged to be offset from one another, by an amount below the resolving power of the unaided eye, with respect to a reference position (x) corresponding to the regular arrangement of the irradiation points (11), the offset of the irradiation points (11) being provided randomly non-uniformly over a relatively large subarea of the cylinder which has a large number of irradiation points (11) (Figure 5).

12. Method according to Claim 11, characterized in that all the irradiation points (11) are arranged in such a way that the pattern corresponding to them in each case is offset with respect to the reference position (x) [central arrangement of the pattern of the individual irradiation points (11)].

13. Method according to one of the preceding claims, characterized in that different irradiation points (11A, 11B, 11C, 11D) are assigned different patterns (Figure 4).

14. Method according to one of the preceding claims, characterized in that the radiation-sensitive layer on the cylinder (10) is a photosensitive layer, which is illuminated by means of visible radiation.

15. Method according to one of the preceding claims, characterized in that laser radiation (1, 2) is used to irradiate the surface (9) of the cylinder.

**Revendications**

1. Procédé de réalisation de cylindres imprimés ou gravés (10), comportant une surface (9) à motif spatial, au moyen d'un procédé de lithographie, selon lequel une couche sensible aux rayonnements, constituant la surface (9) du cylindre (10), est soumise à une élimination ou à un enlèvement localisé, en étant soumise à un rayonnement, par points et progressivement, au moyen d'un faisceau de rayonnement (2) obtenu par formation d'image ou projection sur la couche, d'une manière correspondant au motif voulu, et, de ce fait, la surface (9) du cylindre (10) présente un motif, caractérisé en ce que les points d'incidence de rayonnement (11) sont produits au moyen de faisceaux (2A, 2B) qui, avant l'incidence sur la surface (9) du cylindre (10) et en vue de la réalisation de structures fines dans chaque point d'incidence de rayonnement (11), font l'objet de modifications au moyen d'un élément de formation de faisceau (5) en fonction du motif voulu, puis font l'objet d'une formation d'image ou d'une projection sur la surface de cylindre (9), et en ce que le motif de chaque point d'incidence de rayonnement (11), obtenu par formation d'image ou projection sur la surface de cylindre (9), est entraîné dans un déplacement synchronisé avec le déplacement de la surface de cylindre (9), en fonction de la rotation de celle-ci.

2. Procédé suivant la revendication 1, caractérisé en ce qu'un élément diffractant les rayonnements, de préférence un réseau de diffraction ou un élément agissant d'une manière correspondant à un réseau de diffraction, est utilisé en tant qu'élément de formation de faisceau (5).

3. Procédé suivant la revendication 1 ou 2, caractérisé en ce qu'est utilisé un élément de formation de faisceau (5) dont la structure provoque un déphasage dans le faisceau à former et produit de ce fait un motif d'interférence.

4. Procédé suivant la revendication 3, caractérisé en ce qu'une structure de phase de Ronchi est utilisée en tant qu'élément de formation de faisceau (5).

5. Procédé suivant l'une des revendications précédentes, caractérisé en ce que, pour produire un déplacement du faisceau (2A, 2B), faisant l'objet d'une formation d'image ou d'une projection, qui forme chaque fois le point d'incidence de rayonnement (11), l'élément de formation de faisceau (5) est déplacé d'une manière synchronisée avec le déplacement de la surface de cylindre (9).

6. Procédé suivant l'une des revendications précédentes, caractérisé en ce qu'est utilisé un élément de formation de faisceau (5) dont les propriétés de formation de faisceau sont modifiables (12).

7. Procédé suivant la revendication 6, caractérisé en ce qu'un convertisseur acousto-optique est utilisé en tant qu'élément de formation de faisceau (5).

8. Procédé suivant la revendication 6 ou 7, caractérisé en ce que l'élément de formation de faisceau (5) est commandé (12) de manière à produire un déplacement du motif ayant lieu d'une manière synchronisée avec la rotation de la surface de cylindre (9) .

9. Procédé suivant l'une des revendications précédentes, caractérisé en ce que, pour la réalisation du motif voulu au moyen des points d'incidence de rayonnement (11), la surface (9) du cylindre (10) est soumise à un rayonnement ligne par ligne (14) et/ou en forme d'hélice (15).

10. Procédé suivant la revendication 9, caractérisé en ce que, dans des lignes (14) ou des lignes d'hélice (15) voisines, les points d'incidence de rayonnement (11) sont disposés d'une manière légèrement décalée l'un par rapport à l'autre (figure 5).

11. Procédé suivant l'une des revendications précédentes, caractérisé en ce que des points d'incidence de rayonnement (11) voisins l'un de l'autre sont disposés d'une manière décalée l'un par rapport à l'autre, d'une certaine valeur, inférieure au pouvoir séparateur de l'oeil non pourvu d'auxiliaires, par rapport à une position de consigne (x) correspondant à un agencement régulier des points d'incidence de rayonnement (11), le décalage des points d'incidence de rayonnement (11) étant prévu, d'une manière statistiquement non équilibrée, sur une plus grande surface partielle de cylindre comportant de multiples points d'incidence de rayonnement (11) (figure 5).

12. Procédé suivant la revendication 11, caractérisé en ce que tous les points d'incidence de rayonnement (11) sont disposés d'une manière telle que le motif correspondant à chacun de ceux-ci est décalé par rapport à la position de consigne (x) [agencement centré du motif des différents points d'incidence de rayonnement (11)].

13. Procédé suivant l'une des revendications précédentes, caractérisé en ce que des motifs différents sont associés à des points d'incidence de rayonnement (11A, 11B, 11C, 11D) différents (figure 4).

14. Procédé suivant l'une des revendications précédentes, caractérisé en ce que la couche sensible aux rayonnements située sur le cylindre (10) est une couche photosensible qui est éclairée au moyen d'un rayonnement lumineux.

15. Procédé suivant l'une des revendications précédentes, caractérisé en ce qu'un rayonnement laser (1, 2) est utilisé pour l'application de rayonnement sur la surface de cylindre (9).

FIG.1

FIG.2

FIG.3

FIG.4

FIG.5